# EUROPEAN PATENT SPECIFICATION

(11) **EP 0 402 616 B1**
(45) Date of publication and mention of the grant of the patent: **05.07.1995**
(21) Application number: 90108568.8
(22) Date of filing: 07.05.1990
(51) Int. Cl.: G03F 7/115, H01J 29/07

(54) **Emulsion printing plate relief coatings**
Emulsionsbeschichtungen für Druckplattenrelief
Couches à émulsion pour les reliefs de planches d'impression

(30) Priority: 09.06.1989 US 363911
(43) Date of publication of application: 19.12.1990
(73) Proprietor: BMC INDUSTRIES, INC., Minneapolis, MN 55420 (US)
(72) Inventor: Deibler, Dean T., Cortland NY 13045 (US); Marcanio, Joseph A., Cortland NY 13045 (US)
(74) Representative: Modiano, Guido, Dr.-Ing.

(56) References cited:
- US-A- 4 664 996
- US-A- 4 669 871

## Description

This invention relates generally to photo printing plates and, more specifically, to relief coatings for emulsions on printing plates used to lay out etchant patterns in etchant resist on metal webs.

### BACKGROUND OF THE INVENTION

In a colored cathode ray picture tube a shadow mask or aperture mask is located between the electron guns at the rear of the tube and the phosphor coated face plate at the front of the tube. Electron beams pass through tiny openings or apertures in the shadow mask and impinge upon suitable color producing phosphor dots, a triad one dot for each of the three primary colors. During operation of the picture tube the shadow mask openings are used as a guide for the electron beams.

In order to manufacture the shadow masks for use in the cathode ray tubes that are used in color monitors it is necessary to proceed through a number of steps to etch a metal web into a shadow mask having the small precision openings of proper dimensions and proper location. In a typical shadow mask manufacturing process one has to first make a photographic printing plate that is referred to as a photo printing plate for use in forming an etchant resist pattern in a layer of etchant resist located on the surface of a metal web. One of the methods used to to create a photo printing plate involves applying a layer of a light sensitive emulsion to a sheet of flat glass. The emulsion layer is exposed to a light source to form a first etchant resist pattern in the emulsion. The emulsion is then developed to produce a master etchant resist pattern for defining the etchant resist pattern in the layer of etchant resist located on a metal web or sheet. Since precision etching of small openings usually requires selective etching from both sides of the metal web a second photo printing plate is created for laying out a second etchant resist pattern in the layer of etchant resist that is located on the opposite side of the metal web. Once the photo printing plates are made the user positions the photo printing plates in register on opposite sided of the metal web and in contact with the respective layer of etchant resist on the metal web. Next, one draws the photo printing plates into intimate contact with the etchant resist by evacuating the air between the photo printing plates and the layers of etchant resist on the metal web. Next one selectively exposes the light sensitive etchant resist layer through the photo printing plates. After exposing the light sensitive etchant resist to a suitable light source one develops the etchant resist. During developing, the soluble portions of the etchant resist are removed leaving a pattern of openings in the etchant resist. The openings in the etchant resist permit an operator to use an etchant to etch the metal web in the areas not protected by the etchant resist.

A commonly used light sensitive etchant resist is fish glue which is applied as a liquid and allowed to dry forming a layer of etchant resist that has a thickness of about 3 to 10 microns.

One of the problems in accurately etching openings in a metal web is the difficulty in accurately laying out the etchant resist pattern in the fish glue layers on the metal web. Two types of photo printing plates are used in the art. In the more accurate but costly process a very thin etchant resist master pattern is formed by deposition of a thin (less than 0,5 microns) layer of a metal oxide on a glass plate. In the less costly but less precise method a master pattern is formed in an emulsion layer about 3 to 5 microns thick. The actual opaque pattern formed with emulsions sits slightly embedded in the surface of the emulsion and projects outward from the emulsion surface a distance of about one micron. Since the accuracy of the image formed in the etchant resist layer on the metal web is a function of how close the pattern on the photo printing plate is to the etchant resist layer it is extremely important that the master pattern on the photo printing plate is in as close proximity as possible to the layer of etchant resist.

In the emulsion type printing plate one coats a glass plate with a layer of light sensitive emulsion that is about 3 microns thick. Next a primary master pattern having opaque areas and nonopaque areas is placed over the layer of emulsion. Then the light sensitive emulsion is exposed to light and developed to form a pattern of opaque regions on top of the clear or non opaque emulsion layer. After developing the emulsion on the photo printing plate one has a photo printing plate with a master pattern formed by a relatively soft clear compressible emulsion base with an opaque master pattern projecting about 1 micron above the top surface of the clear emulsion. To expose and develop the light sensitive etchant resist on the metal web one draws the photo printing plate with the patterned emulsion layer into intimate contact with the etchant resist through application of a vacuum to the region between the emulsion layer and the etchant resist. The projections from the surface of the emulsion form channels that permit the air to be evacuated from the central regions of the photo printing plate.

One of the problems with the use of thick soft emulsions for the master pattern on a photo printing plates is that the opaque master pattern projections on the emulsion form a gasket like seal with the etchant resist on the metal web. If there are any enclosed regions defined in the photo printing plate the gasket like seal makes it difficult to evacuate the air from between the emulsion layer and the etchant resist. This problem is particularly acute along the region of the master pattern that is referred to as the strip line. The strip line is a an opaque band encircling a dot arrary pattern located on interior portion of the master pattern. During the exposing and developing of the etchant resist pattern on the etchant resist the opaque master pattern projection of the strip line is drawn into contact with the etchant resist by evacuating the air between the emulsion layer and the etchant resist layer. In the prior art processes the emulsion pattern strip lines usually have had sufficient breaks or irregularities so that gaps or breaks in the emulsion pattern strip line permit evacuation of the air from within the region defined by the strip line. With the present invention we have discovered that we do not need to rely on irregularities in the emulsion master pattern of the strip line. We preserve the accuracy of etchant resist pattern by application of a set of spacers on top of the soft emulsion base to provide a path for air to escape past the strip line. The use of spacers projecting upward from the emulsion base without any detrimental degradation of the image developed therefrom is not fully understood in view of the problems encountered with foreign particles that occasional come into contact with the tops of the opaque master pattern image on the emulsion. The foreign particles on top of the emulsion projections usually result in fracture of the emulsion opaque image when a vacuum is drawn between the emulsion layer and the etchant resist layer thus rending the photo printing plate unsuitable for use in laying out an accurate etchant resist pattern on the etchant resist on the metal web.

### DESCRIPTION OF THE PRIOR ART

The U.S. Mears patent 2,710,591 and 2,710,814 show a machine for producing a light sensitive etchant resist coating on a metal web that is to be etched into a shadow mask.

The U.S. Mears patent 2,720,146 shows a photo printing apparatus that is used to draw the photo printing plates into surface contact with the etchant resist on the metal web.

The U.S. Mears patent 2,751,829 shows a machine for developing and heat treating the etchant resist coatings on a metal web.

The U.S. Mears patent 2,791,514 shows an apparatus and method for coating a metal web with a liquid coating of an etchant resist and than drying the coating to form a continuous etchant resist coating over a metal web.

The U.S. Mears patent 2,762,149 shows a method for etching a metal web selectively coated with an etchant resist.

The U.S. Mears patent 2,786,443 shows an apparatus for applying a coating of etchant resist to a vertically held metal web.

The U.S. Mears patent 2,814,975 shows a photo printing apparatus for holding photo printing plates in register on opposite sides of a metal web with chambers along the periphery of the photo printing plate to permit one to evacuate the air between the emulsion layer on the printing plate and the etchant resist.

The U.S. Brown patent 3,199,430 shows a photo printing apparatus for holding printing plates in register with the photo printing frame using ball socket joints.

The U.S. Wickland patent 2,757,087 shows a method of making the master etchant resist pattern that is to be formed on a photo printing plates by using a ruled glass plate having a set of opaque, parallel lines that are used to make three identical prints on a photographic film. The three prints are then overlaid one another and rotated to produce the desired pattern of openings. After producing the desired primary master pattern of openings the primary master pattern is reproduced in a light sensitive emulsion on a photo printing plate which is subsequently used to lay out the pattern of openings in the etchant resist on a metal web.

The prior art Mears and Brown patents taught the use of evacuating the region between the photo printing plate and the etchant resist to tightly sandwich the emulsion master pattern against the etchant resist. The more intimate and thorough contact between the photo printing plate and the etchant resist generally the sharper the image one can obtain. One of the problems with photo printing plates that use emulsion coatings is that the emulsion coating being relative soft sometimes form gasket like seals against the etchant resist. In order to decrease the time necessary to evacuate the air from between the emulsion master pattern and and the etchant resist various types of air evacuation channels have been formed in the emulsion coating.

For example the U.S. Detrick patent 3,897,251 teaches one to expose and remove the emulsion between the opaque portions of the master pattern thereby leaving islands of emulsion master patterns with channels therebetween to permit the air to be rapidly evacuated between the photo printing plate and the etchant resist.

Still another method of decreasing the evacuation time for emulsion coated printing plates is shown in the U.S. Tiala patent 3,615,468 which teaches one to incorporate hard abrasive particles having dimensions up to 100 microns thick into the emulsion coating. The hard abrasive particles which are located in the soft emulsion extend through the emulsion to act as spacers between the photo printing plate and the etchant resist layer on the metal web thereby decreasing the evacuation time. The hard abrasive particles which are thicker than the emulsion layer extend through the emulsion layer to contact the etchant resist and prevent the etchant resist from coming into surface contact with the emulsion layer. Tiala points out that the island particles can be dispersed throughout emulsion since the light apparently diffuses around the small particles to permit exposure of the etchant resist on the metal web.

Another method of increasing the spacing between the thin hard master pattern and the etchant resist is described in Moscony et al. patents 4,588,676; 4,656,107 & 4,664,996. In general the Moscony et al. prior art patents vapor deposit a hard thin iron oxide coating on a glass master plate to form a photo printing plate. The iron oxide coatings may be up to twenty times thinner than the emulsion coatings. The thinner coatings also make it difficult to quickly evacuate the region between the printing plate and the etchant resist layer on the metal web. In order to minimize the delay in evacuating the air from between the photo printing plate and the coating of etchant resist on the metal webs the Moscony et al. patents like Tiala have built islands or spacers to provide larger evacuation paths. The Moscony et al. patents place rubbery islands on top of the thin, hard master pattern and the glass support plate to provide deeper evacuating channels between the master pattern and the etchant resist.

More specifically the U.S. Moscony et al. patents 4,588,676; 4,656,107 & 4,664,996 teach the placement of rubbery islands over the thin hard master patterns to provide deeper channels for the air to be evacuated from between the master pattern and the etchant resist. Tiala uses islands of hard abrasive particles that extend down to the glass support plate to provide the spacing support thereby increasing the depth of the channels which decreases the evacuation time necessary to remove air form between the emulsion and the etchant resist layer on the metal web. Moscony et al. points out that the problems in providing evacuation channels in the emulsion coated printing plates are grossly different than the problems in providing evacuation channels for master patterns of hard, non-tapered, grossly-thinner, fully-opaque portions. In its prosecution history Moscony et al points out "that the fact that the coating is rubbery has little effect on a structure with an emulsion master pattern (which is compressible), but this feature produces substantial benefits in combination with the grossly thinner master pattern..." In contrast to the teachings of Moscony et al and Tiala that use a hard glass surface for their spacer particles the present invention utilizes spacers not on the glass support surface but on top of both the opaque and the nonopaque compressible emulsion pattern. The spacers form larger evacuation channels between the emulsion master pattern the etchant resist layer on the metal web. In addition by positioning the spacers on regions other than the strip lines one can provide for the rapid evacuation of air from between the emulsion layer and the etchant resist that are located on the interior regions of the photo printing pattern.

Another prior art patent is the Wetzel et al. U.S. patent 4,669,871 which lists as one of its inventors Dean Deibler a coinventor of the present invention. The Wetzel et al. patent teaches one to substitute the prior are randomly cut air evacuation grooves in the peripheral area of the hard thin coatings master for more precisely defined channels of rubbery material that are located directly on the surface of the glass support plate.

The air evacuation channels formed in the peripheral area are larger than the channels located on the central region of glass to thereby insure that the air can be rapidly evacuated from between the hard master pattern and the etchant resist.

Accordingly, it is an object of the present invention the arrangement of spacers on top of an emulsion layer, such that a continuous path for the air is possible over a strip line of a cathode ray tube.

This object and other objects which will become apparent hereinafter are achieved by an emulsion coated printing plate for laying out a shadow mask pattern in etchant resist on a metal web and a method of etching aperture masks for cathode ray tubes, as defined in the accompanying claims.

### BRIEF DESCRIPTION OF THE DRAWINGS

Figure 1 shows a front view of a prior art photo printing plate with an emulsion coating having an opaque master pattern defined in the emulsion coating;
Figure 2 shows a front view of the photo printing plate of figure 1 overlaid with spacers;
Figure 3 shows a side view of the photo printing plate of figure 2 and a second photo printing plate in register on opposite sides of layers of etchant resist on a metal web;
Figure 4 shows an enlarged sectional view of a portion of the printing plate of the present invention;
Figure 5 shows a partial sectional view of a portion of a prior art emulsion image in cross section;and
Figure 6 shows a sectional view of a portion of the present invention coated with a layer of silicone.

### SUMMARY OF THE INVENTION

Briefly, the present invention comprises a photo printing plate having the combination of a compressible emulsion layer with spacers of a first height located partially on top of the opaque pattern that projects outward from the compressible emulsion layer and partially on top of the nonopaque compressible emulsion layer adjacent to to the opaque pattern to provide larger evacuation channels over the compressible emulsion surface and the strip line without substantially degrading the image that can be formed on a layer of etchant resist with the photo printing plate. The areas defined by the strip lines containing substantially no spacers to permit the air to be evacuated over the strip lines and between the emulsion layer on the photo printing plate and the etchant resist coating on the metal web. In the region outside the strip lines the spacers are supported entirely on top of the compressible emulsion layer to provide peripheral spacing support for the printing plate.

### DESCRIPTION OF THE PREFERRED EMBODIMENT

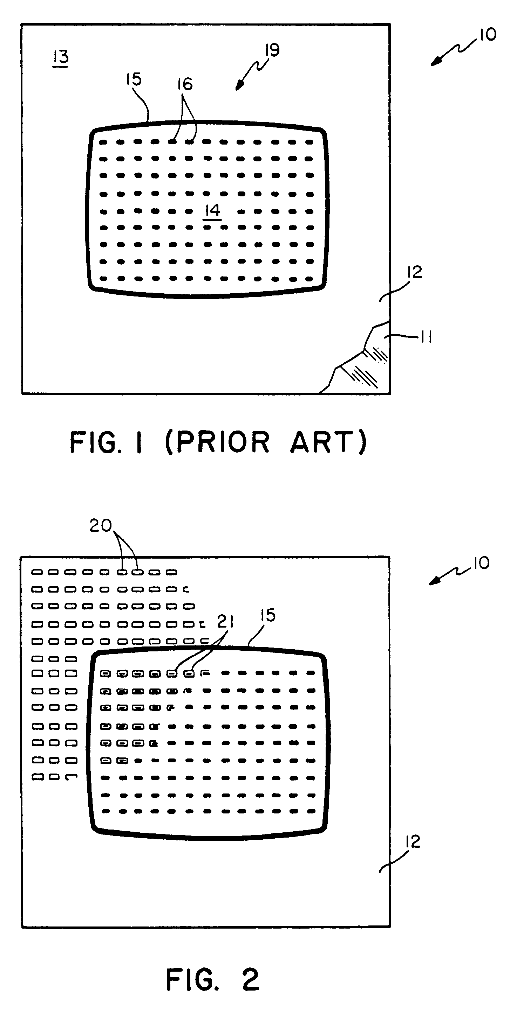

Referring to Figure 1 reference numeral 10 identifies a conventional photo printing plate 10 having a flat glass support plate 11 with a compressible emulsion layer 12 extending over the surface of a glass plate 11. Located in and projecting outward from emulsion 12 is an opaque pattern formed by a set of opaque regions 19 that are to be used to layout the exposed metal pattern in a layer of etchant resist on a metal web. Figure 1 shows the opaque master pattern outline of a shadow mask 19 comprising a central located set of elongated opaque regions 16 and an encircling opaque band 15 that is referred to as a strip line. The purpose of the opaque elongated regions 16 is to define the exposed metal regions in the etchant resist that form the boundaries of the openings through the shadow mask. The purpose of the opaque strip line 15 is to define the exposed metal regions in the etchant resist that form the boundaries of the shadow mask. When the exposed metal regions are etched away one forms an etched shadow mask that can be cleanly removed from the metal web without introducing stress to the shadow mask that may cause distortions of the mask during use in a picture tube. Located outside strip line 15 is an outer clear or non opaque annular like region 13 and located between strip line 15 and the elongated pattern 16 is an inner annular like clear or non opaque boundary region 14. While elongated regions are shown other shapes such as circular or the like could be used.

Figure 2 shows photographic plate 10 with an overlay of a plurality of clear or nonopaque spacers 20 that are selectively and substantially uniformly spaced over the photo printing plate 10 with the exception of the strip line 15. Spacers 20 are typically formed from resin materials such as polyvinyl cinnamate derivatives which are commercially available under tradenames such as Waycoat RC and KPR. Spacers 20 can be formed by conventional techniques of applying a layer of material on top of the emulsion layer and then exposing, developing and washing away the undesired area to leave a plurality of spacers located throughout the surface of the emulsion layer. The spacers 20 are located in a substantially uniform pattern throughout the entire surface region of the emulsion coated printing plate 10 with the exception of the opaque region 15 that defines the strip line.

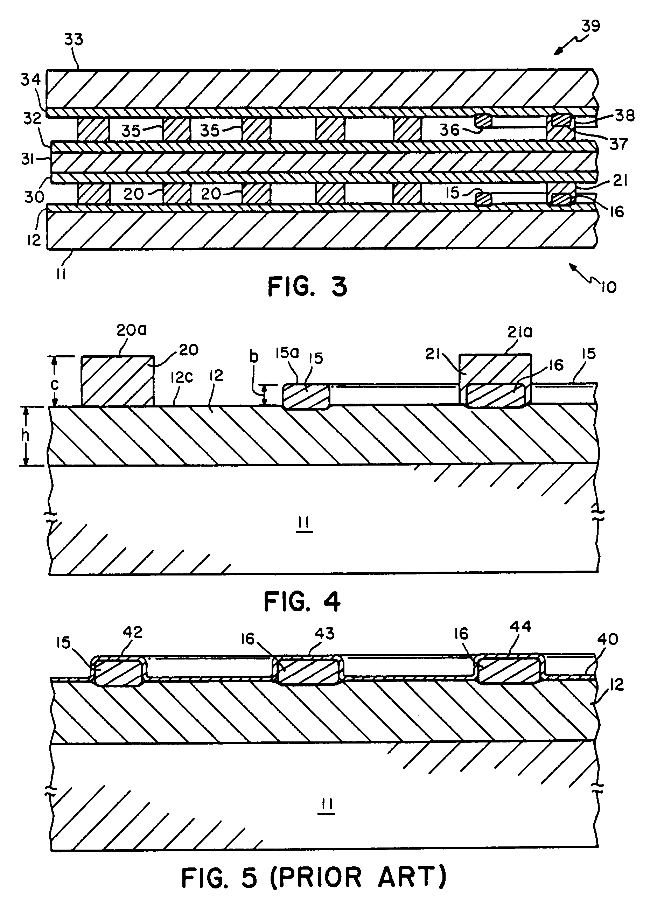

In order to understand the operation of my spacers and the position of the spacers reference should be made to figure 3 which shows a sectional end view of a portion of pair of photo printing plates 10 and 39 sandwiched against a light sensitive etchant resist coated metal web 31. Located in the center of figure 3 is metal web 31 having a first layer of light sensitive etchant resist 32 on one side of metal web 31 and a second layer of light sensitive etchant resist 30 located on the opposite side of metal web 31. Typically, the light sensitive etchant resist layers 30 and 32 comprise fish glue. To form the light sensitive etchant resist layers 30 and 32 into an etchant resistant surface the light sensitive etchant resists are exposed to a light source, developed, and then washed away thus leaving exposed metal areas in the etchant resist. By applying an etchant to the exposed metal web one can form precision openings through the metal web. Typically, steel webs are etched through with an etchant such as ferric chloride.

Located in intimate contact with layer of etchant resist 30 is the top surfaces of the photo printing plate 10 and located in intimate contact with the layer of etchant resist 32 is the top surface of photo printing plate 39. The top surfaces of photo printing plates 10 and 39 are brought into intimate contact with the respective layer of etchant resist through the type of prior art printing frames as shown in assignees prior art Brown patent 3,199,430 and Mears patent 2,814,975. To obtain intimate contact between the printing plates and the layers of etchant resist the air is evacuated between the etchant resist layers and the photo printing plates to draw the surface of the printing plate into intimate contact with the light sensitive etchant resist 32 and 30.

Figure 3 shows that a path for evacuation of air between emulsion layer 12 and the etchant resist 30 is provided for by the post like spacers 20 and 21. Similarly, the post like spaced 35 ad 38 provide a path for evacuation of air between emulsion layer 34 and etchant resist 32.

In order to appreciate the relative height and the location of the spacers with respect to the strip line reference should be made to figure 4 which shows a compressible emulsion layer 12 of thickness h of 3 microns, a peripheral spacer 20 of height c of 2.5 microns and an opaque strip line 15 and an opaque pattern 16 having a height b of one micron. A closer inspection of the spacers 20 and 21 shows that peripheral spacers 20 are located entirely on the clear or nonopaque compressible emulsion on the peripheral regions of glass plate 11. Located in the central area of the printing plates and supported partially on the compressible emulsion layer and partially on the opaque pattern 16 are clear spacers 21. Figure 4 also shows that there are substantially no spacers located on the opaque strip line 15 thereby providing an air evacuation path over the barrier formed by the encircling strip line 15. Thus the present invention through the use of two types of clear spacers located either entirely on the compressible emulsion 12 or partially on the compressible emulsion 12 and partially on the opaque pattern 16 provides air evacuation channels from the central region of the photo printing plate to the peripheral region of the photo printing plate over strip line 15. In addition the use of spacers both on top of the master pattern located on the emulsion layer and on top of the non opaque emulsion pattern produces air evacuation paths that permit a user to quickly evacuate the air from between the emulsion layer and the etchant resist.

Figure 5 shows a cross sectional view of a portion of a prior art emulsion printing plate 10 in the region of opaque master patterns 16. Typically, the prior art photo printing plates include a continuous thin coating of a release or wear agent such as silicone layer 40. Protective silicone layers have been used to prevent dirt from adhering to the face of the printing plate during the use and reuse of the printing plates. It has been found that if particles come into contact with the opaque projection which are usually silver emulsion the opaque silver projections may fracture and thus render the opaque pattern unsuitable for use in laying out patterns in the etchant resist. The prior art use of the silicone layer 40 was used to protect the top surfaces of the opaque emulsions from accidental having to support any foreign object. Ironically, In contrast to the prior art that attempted to avoid placement of foreign objects on top of the opaque projections the present invention deliberately places spacers on top of the opaque projections and on the compressible emulsion layer adjacent the opaque projections.

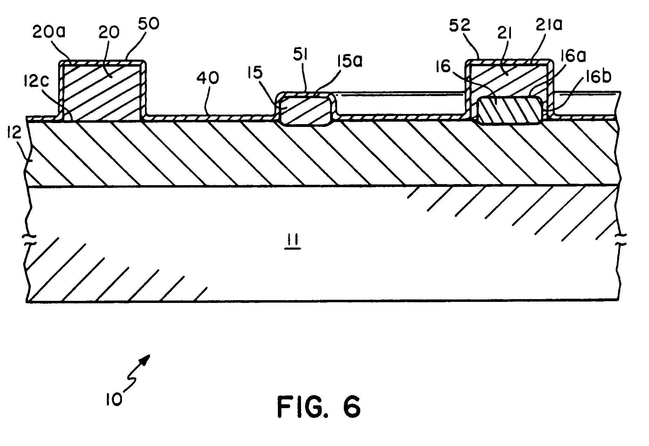

In order to compare the evacuation paths formed by the present invention and the prior art reference should be made to figure 5 and figure 6. Figure 5 shows a prior art emulsion master pattern on a photo printing plate 10. Located on emulsion layer 12 are the opaque master patterns 16 that represent the interior region of the mask and the opaque master patterns 15 that represents the continuous strip line. Located on top of the emulsion layer is a coating of silicone 40 that is used to prevent dirt particles from clinging to the photo printing plate during use and reuse of the photo printing plates. During the printing process the layer of etchant resist on the metal web would be in contact with top surfaces 42, 43, and 44. Note that in the prior art without the island spacers such as shown in Tiala the evacuation paths from the center of the mask to the outside region of the mask are obstructed unless one forms breaks or irregularities in strip line 15.

In contrast figure 6 shows an enlarged sectional view similar to figure 5 with interior spacers 21 located on interior emulsion opaque patterns 16 and peripheral spacers 20 located on the region outside of the strip line 15. In order to keep dirt particles off the photo printing plate a thin layer of silicone 40 is located over emulsion 12 and the emulsion projections. During the process of forming the image in the etchant resist a layer of etchant resist would be place in contact with top surface 50 that is located on top surface 20a of spacer 20 and on top surface 52 that is located on top surface 21a of spacer 21. Figure 6 shows that the strip line 15 is substantially free of any spacers so that the air can be quickly and easily evacuated from the region interior to the strip line. Thus the present invention provides for the removal of air from between the emulsion layer and the etchant resist by placement of spacers on top of the emulsion layer rather than by placement of spacers in contact with the glass support plate as described in Tiala and as shown in the Moscony et al. patents.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. An emulsion coated printing plate for laying out a shadow mask pattern in etchant resist on a metal web (31) comprising:
a transparent plate (10,39) having a top surface;
a layer (12,34) of compressible emulsion located on said top surface, said layer (12,34) of compressible emulsion having a first surface;
a first opaque pattern (16,37) located on said first surface, said first opaque pattern (16,37) projecting upward from said first surface of said layer (12,34) of compressible emulsion to define a channel for evacuation of air between said first surface of said layer (12,34) of compressible emulsion and a layer (30,32) of etchant resist;
a strip line forming a second opaque pattern (15,36) enclosing said first opaque pattern (16,37), said strip line defining an interior region being encompassed by said strip line and an exterior region located outside said strip line;
a plurality of first spacers (21,38) located on said first opaque pattern (16,37) to space said first opaque pattern (16,37) from said layer (30,32) of etchant resist; and
a plurality of second spacers (20,35) located at said exterior region to space said layer (12,34) of compressible emulsion from said layer (30,32) of etchant resist so that the air can be evacuated from said interior region through said exterior region whereby an air evacuation channel is provided over said strip line by said first plurality of spacers (21,38) and said second plurality of spacers (20,35).

2. The emulsion coated printing plate according to claim 1, wherein said second spacers (20,35) are located entirely at said exterior region on top of said first surface of said layer (12,34) of compressible emulsion.

3. The emulsion coated printing plate according to claims 1 or 2, wherein said opaque patterns (16,37,15,36) comprise projections extending about one micron above said layer (12,34) of compressible emulsion.

4. The emulsion coated printing plate according to one or more of the preceding claims, wherein said spacers (21,38,20,35) are spaced substantially uniformly over said layer (12,34) of compressible emulsion.

5. The emulsion coated printing plate according to one or more of the preceding claims, wherein no spacers are located on said strip line.

6. The emulsion coated printing plate according to one or more of the preceding claims, wherein said spacers (21,38,20,35) and said emulsion layer (12,34) are covered with a silicone layer (40) to prevent dirt particles from adhering to said printing plate during use and reuse.

7. The emulsion coated printing plate according to one or more of the preceding claims, wherein said layer (12,34) of compressible emulsion is comprised of a nonopaque emulsion.

8. The emulsion coated printing plate according to one or more of the preceding claims, wherein said plurality of spacers (21,38,20,35) are partially located on said layer (12,34) of compressible emulsion and partially on said first opaque pattern (16,37).

9. The emulsion coated printing plate according to one or more of the preceding claims, wherein said spacers (21,38,20,35) extend approximately 3 microns above said top surface to thereby define air evacuation channels between said spacers (21,38,20,35).

10. The emulsion coated printing plate according to one or more of the preceding claims, wherein said layer (12,34) of compressible emulsion is about 3 microns thick

11. The emulsion coated printing plate according to one or more of the preceding claims, wherein said spacers project a minimum of 2 microns above said layer (12,34) of compressible emulsion.

12. The emulsion coated printing plate according to one or more of the preceding claims, wherein said spacers (21,38,20,35) are positioned in a regular pattern throughout the first surface.

13. A method of etching aperture masks for cathode ray tubes comprising the steps of:
forming a layer (12,34) of compressible emulsion on a support plate (10,39);
placing a primary master pattern having opaque and nonopaque areas over said layer (12,34) of compressible emulsion and exposing said layer (12,34) of compressible emulsion;
selectively developing the layer (12,34) of compressible emulsion to produce a first opaque pattern (16,37) and a strip line forming a second opaque pattern (15,36) that project outwardly from the layer (12,34) of compressible emulsion;
placing spacers (21,38,20,35) on top of said first opaque pattern (16,37) and on top of said layer (12,34) of compressible emulsion that does not have said first opaque pattern (16,37) whereby an air evacuation channel is provided over said strip line by said spacers (21,38,20,35);
placing said spacers (21,38,20,35) against a layer (30,32) of etchant resist located over a material (31) to be etched;
evacuating the air from between said layer (12,34) of compressible emulsion and said layer (30,32) of etchant resist;
then developing said layer (30,32) of etchant resist so that the material not covered by the etchant resist can be etched; and
then etching the material with the etchant resist to produce an aperture mask.

14. The method of etching aperture masks for cathode ray tubes according to claim 13, wherein opaque patterns (16,37,15,36) project about one micron outward from the top surface of said layer (12,34) of compressible emulsion.

## Patentansprüche

1. Eine Emulsions-beschichtete Druckplatte zur Bildung eines Lochmaskenmusters in einem Ätzmittel-Resist auf einem Metallgewebe (31), umfassend:
eine transparente Platte (10, 39), die eine obere Fläche aufweist;
eine Schicht (12, 34) aus einer kompressiblen Emulsion, die auf der oberen Fläche aufgetragen ist, wobei die kompressible Emulsionsschicht (12, 34) eine erste Oberfläche aufweist;
ein erstes lichtundurchlässiges Muster (16, 37), das an der ersten Oberfläche angebracht ist, wobei das erste lichtundurchlässige Muster (16, 37) von der ersten Oberfläche der kompressiblen Emulsionsschicht (12, 34) nach oben ragt, um einen Kanal zur Luftevakuierung zwischen der ersten Oberfläche der kompressiblen Emulsionsschicht (12, 34) und einer Schicht (30, 32) von Ätzmittel-Resist zu bilden;
eine Streifenlinie, die ein zweites lichtundurchlässiges Muster (15, 36) bildet, das das erste lichtundurchlässige Muster (16, 37) umschließt, wobei die Streifenlinie einen inneren Abschnitt, der von der Streifenlinie umgeben ist, und einen äußeren Abschnitt, der sich außerbalb der Streifenlinie befindet, bildet;
eine Vielzahl von ersten Abstandshaltern (21, 38), die auf dem ersten lichtundurchlässigen Muster (16, 37) angebracht sind, um das erste lichtundurchlässige Muster (16, 37) von der Schicht (30, 32) Ätzmittel-Resists zu beabstanden; und
eine Vielzahl von zweiten Abstandshaltern (20, 35), die an dem äußeren Abschnitt angebracht sind, um die kompressible Emulsionsschicht (12, 34) von der Ätzmittel-Resistschicht (30, 32) zu beabstanden, so daß die Luft aus dem inneren Abschnitt bis zum äußeren Abschnitt evakuiert werden kann, wobei durch die erste Vielzahl von Abstandshaltern (21, 38) und die zweite Vielzahl von Abstandshaltern (20, 35) ein Luftevakuierungskanal über der Streifenlinie bereitgestellt wird.

2. Die Emulsions-beschichtete Druckplatte gemäß Anspruch 1, worin die zweiten Abstandshalter (20, 35) gänzlich am äußeren Abschnitt oben auf der ersten Oberfläche der kompressiblen Emulsionsschicht (12, 34) angebracht sind.

3. Die Emulsions-beschichtete Druckplatte gemäß der Ansprüche 1 oder 2, worin die lichtundurchlässigen Muster (16, 37, 15, 36) Erhebungen umfassen, die über ungefähr 1 Mikrometer über der kompressiblen Emulsionsschicht (12, 34) nach oben ragen.

4. Die Emulsions-beschichtete Druckplatte gemäß eines oder mehrerer der vorhergehenden Ansprüche, worin die Abstandshalter (21, 38, 20, 35) im wesentlichen gleichmäßig über der kompressiblen Emulsionsschicht (12, 34) verteilt sind.

5. Die Emulsions-beschichtete Druckplatte gemäß eines oder mehrerer der vorangegangenen Ansprüche, worin keine Abstandshalter auf der Streifenlinie angebracht sind.

6. Die Emulsions-beschichtete Druckplatte gemäß eines oder mehrerer der vorhergehenden Ansprüche, worin die Abstandshalter (21, 38, 20, 35) und die Emulsionsschicht (12, 34) mit einer Siliziumschicht (49) überzogen sind, um zu verhindern, daß Schmutzpartikel an der Druckplatte während der Verwendung und Wiederverwendung haften bleiben.

7. Die Emulsions-beschichtete Druckplatte gemäß eines oder mehrerer der vorhergehenden Ansprüche, worin die kompressible Emulsionsschicht (12,34) aus einer nicht lichtundurchlässigen Emulsion besteht.

8. Die Emulsions-beschichtete Druckplatte gemäß eines oder mehrerer der vorhergehenden Ansprüche, worin die Vielzahl von Abstandshaltern (21, 38, 20, 35) teilweise auf der kompressiblen Emulsionsschicht (12, 34) und teilweise auf dem ersten lichtundurchlässigen Muster (16, 37) angebracht sind.

9. Die Emulsions-beschichtete Druckplatte gemäß eines oder mehrerer der vorhergehenden Ansprüche, worin sich die Abstandshalter (21, 38, 20, 35) etwa 3 Mikrometer über der oberen Fläche erstrecken, um dabei Luftevakuierungskanäle zwichen den Abstandshaltern (21, 38, 20, 35) zu bilden.

10. Die Emulsions-beschichtete Druckplatte gemäß eines oder mehrerer der vorhergehenden Ansprüche, worin die kompressible Emulsionsschicht (12, 34) etwa 3 Mikrometer dick ist.

11. Die Emulsions-beschichtete Druckplatte gemäß eines oder mehrerer der vorhergehenden Ansprüche, worin die Abstandshalter mindestens 2 Mikrometer über die kompressiblen Emulsionsschicht (12, 34) hinausragen.

12. Die Emulsions-beschichtete Druckplatte gemäß eines oder mehrerer der vorhergehenden Ansprüche, worin die Abstandshalter (21, 38, 20, 35) in einem regelmäßigen Muster über der ersten Oberfläche angebracht sind.

13. Ein Verfahren zum Ätzen von Lochmasken für Kathodenstrahlröhren, das folgende Schritte umfaßt:
Bildung einer kompressiblen Emulsionsschicht (12, 34) auf einer Stützplatte (10, 39);
Auftragen eines primären Hauptmusters mit lichtundurchlässigen und nicht lichtundurchlässigen Abschnitten über der kompressiblen Emulsionsschicht (12, 34) und Belichten der kompressiblen Emulsionsschicht (12,34);
Wahlweise-Entwicklung der kompressiblen Emulsionsschicht (12, 34), um ein erstes lichtundurchlässiges Muster (16, 37) und eine Streifenlinie, die ein zweites lichtundurchlässiges Muster (15, 36) bildet, zu erzeugen, die von der kompressiblen Emulsionsschicht (12,34) hinausragen;
Anbringen der Abstandshalter (21, 38, 20, 35) über dem ersten undruchsichtigen Muster (16, 37) und über der kompressiblen Emulsionsschicht (12, 34), die nicht das erste lichtundurchlässige Muster (16, 37) aufweist, wodurch ein Luftevakuierungskanal über der Streifenlinie von den Abstandshaltern (21, 38, 20, 35) bereitgestellt wird;
Anbringen der Abstandshalter (21, 38, 20, 35) gegen eine Ätzmittel-Resistschicht (30, 32), die über einem zu ätzenden Material (31) angebracht ist;
Evakuierung der Luft aus dem Bereich zwischen der kompressiblen Emulsionsschicht (12, 34) und der Ätzmittel-Resistschicht (30, 32);
daraufhin das Entwickeln der Ätzmittel-Resistschicht (30, 32), so daß das Material, das nicht vom Ätzmittel-Resist bedeckt ist, geätzt werden kann; und
daraufhin das Ätzen des Materials mit dem Ätzmittel-Resist, um eine Lochmaske herzustellen.

14. Das Verfahren zum Ätzen von Lochmasken für Kathodenstrahlröhren gemäß Ansruch 13, worin die lichtundurchlässigen Muster (16, 37, 15, 36) um ungefähr 1 Mikrometer von der oberen Fläche der kompressiblen Emulsionsschicht (12,34) hinausragen.

## Revendications

1. Planche d'impression recouverte d'une émulsion pour la composition d'un motif de masque perforé en résist de gravure à l'eau-forte sur une bande métallique (31) comprenant :
une plaque transparente (10,39) ayant une surface de dessus ;
une couche (12,34) d'émulsion compressible située sur ladite surface de dessus, ladite couche (12,34) d'émulsion compressible ayant une première surface ;
un premier motif opaque (16,37) situé sur ladite surface, ledit premier motif opaque (16,37) faisant saillie vers le haut depuis ladite première surface de ladite couche (12,34) d'émulsion compressible pour définir un conduit pour l'évacuation de l'air entre ladite première surface de ladite couche (12,34) d'émulsion compressible et une couche (30,32) de résist de gravure à l'eau-forte ;
une ligne à bande formant un deuxième motif opaque (15,36) comprenant ledit premier motif opaque (16,37), ladite ligne à bande définissant une région intérieure étant entourée par ladite ligne à bande et une région extérieure située à l'extérieur ladite ligne à bande ;
une pluralité de premiers intercalaires (21,38) situés sur le premier motif opaque (16,37) pour espacer ledit premier motif opaque (16,37) de ladite couche (30,32) de résist de gravure à l'eau-forte ; et
une pluralité de deuxièmes intercalaires (20,35) situés dans ladite région extérieure pour espacer ladite couche (12,34) d'une émulsion compressible de ladite couche (30,32) de résist de gravure à l'eau-forte, afin que l'air puisse être évacué depuis ladite région intérieure en passant par la région extérieure, d'où le fait qu'un conduit d'évacuation d'air est fourni sur ladite ligne à bande par ladite première pluralité d'intercalaires (21,38) et ladite deuxième pluralité d'intercalaires (20,35).

2. Plaque d'impression recouverte d'une émulsion selon la revendication 1, dans laquelle lesdits deuxièmes intercalaires (20,35) sont entièrement situés dans ladite région extérieure, sur le dessus de ladite première surface de ladite couche (12,34) d'émulsion compressible.

3. Plaque d'impression recouverte d'une émulsion selon la revendication 1 ou la revendication 2, dans laquelle lesdits motifs opaques (16,37,15,36) comprennent des projections se prolongeant d'environ un micron au-dessus de ladite couche (12,34) d'émulsion compressible.

4. Plaque d'impression recouverte d'une émulsion selon l'une ou plusieurs des revendications précédentes, dans laquelle lesdits intercalaires (21,38,20,35) sont substantiellement et uniformément espacés sur ladite couche (12,34) d'émulsion compressible.

5. Plaque d'impression recouverte d'une émulsion selon l'une ou plusieurs revendications précédentes, dans laquelle aucun intercalaire est situé sur ladite ligne à bande.

6. Plaque d'impression recouverte d'une émulsion selon une ou plusieurs des revendications précédentes, dans laquelle lesdits intercalaires (21,38,20,35) et ladite couche d'émulsion (12,34) sont recouverts d'une couche de silicone (40) pour empêcher les particules de poussières d'adhérer à ladite plaque d'impression pendant son utilisation et sa réutilisation.

7. Plaque d'impression recouverte d'une émulsion selon l'une ou plusieurs des revendications précédentes, dans laquelle ladite couche (12,34) d'émulsion compressible est composée d'une émulsion non-opaque.

8. Plaque d'impression recouverte d'une émulsion selon l'une ou plusieurs des revendications précédentes, dans laquelle une pluralité d'intercalaires (21,38,20,35) sont partiellement situés sur ladite couche (12,34) d'émulsion compressible et partiellement sur ledit premier motif opaque (16,37).

9. Plaque d'impression recouverte d'une émulsion selon l'une ou plusieurs des revendications précédentes, dans laquelle lesdits intercalaires (21,38,20,35) se prolongent approximativement de 3 microns au-dessus de ladite surface de dessus, pour ainsi définir des conduits d'évacuation d'air entre lesdits intercalaires (21,38,20,35).

10. Plaque d'impression recouverte d'une émulsion selon l'une ou plusieurs des revendications précédentes, dans laquelle ladite couche (12,34) d'émulsion compressible fait environ 3 microns d'épaisseur.

11. Plaque d'impression recouverte d'une émulsion selon l'une ou plusieurs des revendications précédentes, dans laquelle lesdits intercalaires font saillie au minimum de 2 microns au-dessus de ladite couche (12,34) d'émulsion compressible.

12. Plaque d'impression recouverte d'une émulsion selon l'une ou plusieurs des revendications précédentes, dans laquelle lesdits intercalaires (21,38,20,35) sont positionnés selon une configuration régulière sur toute la première surface.

13. Méthode de gravure de masques perforés pour tubes cathodiques comprenant les étapes de :
formation d'une couche (12,34) d'émulsion compressible sur une plaque support (10,39) ;
positionnement d'un premier motif primaire ayant des zones opaques et non-opaques sur ladite couche (12,34) d'émulsion compressible et exposant ladite couche (12,34) d'émulsion compressible ;
développement sélectif de la couche (12,34) d'émulsion compressible pour produire un premier motif opaque (16,37) et une ligne à bande formant un deuxième motif opaque (15,36) faisant saillie à l'extérieur depuis la couche (12,34) d'émulsion compressible ;
positionnement d'intercalaires (21,38,20,35) sur le dessus dudit premier motif opaque (16,37) et sur le dessus de ladite couche (12,34) d'émulsion compressible qui n'a pas de dit premier motif opaque (16,37), d'où le fait qu'un conduit d'évacuation d'air est fourni sur la ligne à bande par lesdits intercalaires (21,38,20,35) ;
positionnement desdits intercalaires (21,38,20,35) contre une couche (30,32) de résist de gravure à l'eau-forte située sur un matériau (31) à graver ;
évacuation de l'air d'entre ladite couche (12,34) d'émulsion compressible et ladite couche (30,32) de résist de gravure à l'eau-forte ;
puis développement de ladite couche (30,32) de résist de gravure à l'eau-forte afin que le matériau non-recouvert par le résist de gravure à l'eau-forte puisse être gravé ; et
ensuite gravure du matériau avec le résist de gravure à l'eau-forte pour produire un masque perforé.

14. Méthode de gravure à l'eau-forte de masques perforés pour tubes cathodiques selon la revendication 13, dans laquelle des motifs opaques (16,37,15,36) font saillie d'environ 1 micron à l'extérieur depuis la surface de dessus de ladite couche (12,34) d'émulsion compressible.
